# EUROPEAN PATENT APPLICATION

(11) **EP 4 654 773 A1**
(43) Date of publication of application: **26.11.2025**
(21) Application number: 25176059.1
(22) Date of filing: 13.05.2025
(51) Int. Cl.: H10B 12/00

(54) **SEMICONDUCTOR MEMORY DEVICE**

(30) Priority: 22.05.2024 KR 20240066596
(71) Applicant: Samsung Electronics Co., Ltd., Suwon-si, Gyeonggi-do 16677 (KR)
(72) Inventor: NAM, Daejin, Suwon-si, Gyeonggi-do 16677 (KR)
(74) Representative: Kuhnen & Wacker Patent- und Rechtsanwaltsbüro PartG mbB

(57) **Abstract**

A semiconductor memory device includes a substrate (102), an isolation insulating layer arranged on the substrate (102), a plurality of word lines (WL) arranged on the substrate (102) to extend in a first horizontal direction (X) and to be apart from one another in a vertical direction (Z), a bit line (BL) extending in the vertical direction (Z) on the isolation insulating layer, a plurality of semiconductor patterns (110) extending from the bit line (BL) in a second horizontal direction (Y) orthogonal to the first horizontal direction (X) and apart from one another in the vertical direction (Z), and a plurality of information storage elements (SP) connected to the plurality of semiconductor patterns (110). Each of the plurality of semiconductor patterns (110) includes a source region (SD1) including the same impurity as the isolation insulating layer, a drain region (SD2), and a channel region (CH) between the source region (SD1) and the drain region (SD2).

## Description

### BACKGROUND

### 1. Field

The disclosure relates to a semiconductor memory device, and more particularly, to a three-dimensional (3D) semiconductor memory device including a plurality of memory cells arranged in three dimensions.

### 2. Description of Related Art

As miniaturized, multifunctional, and high-performance electronic products are required, high-capacity semiconductor memory devices are required. In order to provide the high-capacity semiconductor memory devices, increased integration is required. Because the degree of integration of a conventional semiconductor memory device including a plurality of memory cells arranged in two dimensions is mainly determined by an area occupied by a unit memory cell, the degree of integration of a two-dimensional (2D) semiconductor memory device is increasing but is still limited. Accordingly, a three-dimensional (3D) semiconductor memory device that increases memory capacity by stacking memory cells in a vertical direction on a substrate to include a plurality of memory cells arranged in three dimensions has been proposed.

### SUMMARY

One or more aspects of the disclosure relate to a three-dimensional (3D) semiconductor memory device with improved electrical reliability.

According to an aspect of the disclosure, there is provided a semiconductor memory device including: a substrate; an isolation insulating layer on the substrate; a plurality of word lines on the substrate, the plurality of word lines extending in a first horizontal direction and being apart from each other in a vertical direction; a bit line extending in the vertical direction on the isolation insulating layer; a plurality of semiconductor patterns extending from the bit line in a second horizontal direction orthogonal to the first horizontal direction and apart from each other in the vertical direction; and a plurality of information storage elements connected to the plurality of semiconductor patterns, wherein each of the plurality of semiconductor patterns includes: a source region connected to the bit line, the source region including a same impurity as the isolation insulating layer, a drain region connected to one of the plurality of information storage elements, and a channel region between the source region and the drain region and at least partially overlapping one of the plurality of word lines, in the vertical direction.

According to another aspect of the disclosure, there is provided a semiconductor memory device including: a substrate; an isolation insulating layer in the substrate; a bit line on the isolation insulating layer, the bit line extending in a vertical direction and including a metal; a plurality of word lines extending in a first horizontal direction and apart from each other in a vertical direction, the plurality of word lines including a first word line provided on a first side of the bit line and a second word line provided on a second side of the bit line, the first word line and the second word line apart from each other in a second horizontal direction orthogonal to the first horizontal direction; a plurality of semiconductor patterns extending in the second horizontal direction and apart from each other in the vertical direction, the plurality of semiconductor patterns including a first semiconductor pattern provided on the first side of the bit line and a second semiconductor pattern provided on the second side of the bit line, and the first semiconductor pattern partially overlapping the first word line in the vertical direction; and a plurality of information storage elements connected to the plurality of semiconductor patterns, wherein each of the plurality of semiconductor patterns includes: a source region connected to the bit line, a drain region connected to one of the plurality of information storage elements, and a channel region between the source region and the drain region, and wherein the source region and the isolation insulating layer include a same impurity.

According to another aspect of the disclosure, there is provided a semiconductor memory device including: a substrate; an isolation insulating layer buried in the substrate and protruding from a top surface of the substrate; a bit line apart from the substrate, the bit line extending in a vertical direction on the isolation insulating layer, and including a metal; a plurality of word lines extending in a first horizontal direction and apart from each other in a vertical direction, the plurality of word lines including a first word line provided on a first side of the bit line and a second word line provided on a second side of the bit line, the first word line and the second word line apart from each other in a second horizontal direction orthogonal to the first horizontal direction; a plurality of semiconductor patterns extending in the second horizontal direction and apart from each other in the vertical direction, the plurality of semiconductor patterns including a first semiconductor pattern provided on the first side of the bit line and a second semiconductor pattern provided on the second side of the bit line, and the first semiconductor pattern passing through the first word line; and a plurality of capacitor structures connected to the plurality of semiconductor patterns and each of the plurality of capacitor structures including: a first electrode, a second electrode, and a capacitor dielectric layer between the first electrode and the second electrode, wherein each of the plurality of semiconductor patterns includes: a source region connected to the bit line, a drain region connected to the first electrode of one of the plurality of capacitor structures, and a channel region between the source region and the drain region, and wherein the source region and the isolation insulating layer include a same impurity.

### BRIEF DESCRIPTION OF DRAWINGS

Embodiments will be more clearly understood from the following detailed description taken in conjunction with the accompanying drawings in which:
FIG. 1 is a block diagram illustrating a semiconductor memory device according to one or more embodiments;
FIG. 2 is an equivalent circuit diagram illustrating a memory cell array of a semiconductor memory device according to one or more embodiments;
FIG. 3A is a perspective view illustrating part of a semiconductor memory device according to one or more embodiments, and FIG. 3B is a cross-sectional view illustrating part of a semiconductor memory device according to one or more embodiments;
FIGS. 4A to 4E are cross-sectional views illustrating a method of manufacturing a semiconductor memory device according to one or more embodiments;
FIGS. 5A and 5B are cross-sectional views illustrating a method of manufacturing a semiconductor memory device according to one or more embodiments, and FIG. 5C is a cross-sectional view illustrating a semiconductor memory device according to one or more embodiments;
FIGS. 6A and 6B are cross-sectional views illustrating semiconductor memory devices according to one or more embodiments;
FIGS. 7A and 7B are cross-sectional views illustrating parts of semiconductor memory devices according to one or more embodiments;
FIG. 8 is an equivalent circuit diagram illustrating a memory cell array of a semiconductor memory device according to one or more embodiments;
FIG. 9A is a perspective view illustrating part of a semiconductor memory device according to one or more embodiments, and FIG. 9B is a cross-sectional view illustrating part of a semiconductor memory device according to one or more embodiments; and
FIGS. 10A and 10B are cross-sectional views illustrating a method of manufacturing a semiconductor memory device according to one or more embodiments.

### DETAILED DESCRIPTION

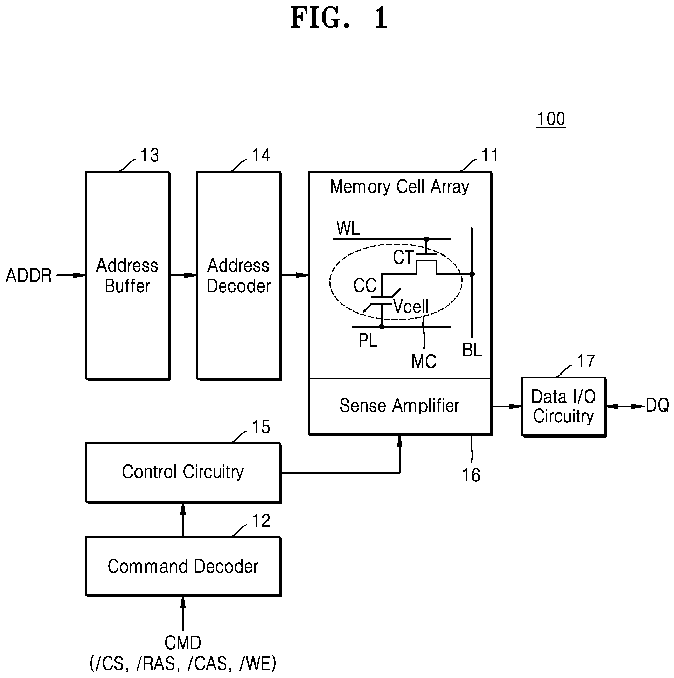

FIG. 1 is a block diagram illustrating a semiconductor memory device 100 according to one or more embodiments.

Referring to FIG. 1, the semiconductor memory device 100 may include a memory cell array 11, a command decoder 12, an address buffer 13, an address decoder 14, a control circuitry 15, a sense amplifier 16, and a data input/output circuitry 17.

The memory cell array 11 may include a plurality of memory cells MC. The memory cell array 11 may include a plurality of word lines WL, a plurality of bit lines BL, and a plurality of plate electrodes PL connected to the plurality of memory cells MC, respectively. The memory cell array 11 may include dynamic random access memory (DRAM) sensing a cell voltage Vcell stored in the memory cell MC as data.

The semiconductor memory device 100 may input/output data DQ in response to a command CMD and an address ADDR received from an external device (for example, a central processing unit (CPU) or a memory controller).

Each of the plurality of memory cells MC may include a cell transistor CT and a cell capacitor CC. A gate of the cell transistor CT may be connected to the word line WL. A first source/drain terminal of the cell transistor CT may be connected to the bit line BL. A second source/drain terminal of the cell transistor CT may be connected to a first terminal of the cell capacitor CC. A second terminal of the cell capacitor CC may be connected to the plate electrode PL. The memory cell MC may store the cell voltage Vcell having a magnitude specifying data in the cell capacitor CC. While the embodiment shown in FIG. 1 comprises an information storage element using a cell capacitor CC, any other information storage element that may store data may be used. The information storage element may e.g. be a memory element using a memory element using a magnetic tunnel junction pattern, or a memory element using a variable resistor including a phase change material.

The command decoder 12 may determine the input command CMD with reference to a chip select signal /CS, a row address strobe signal /RAS, a column address strobe signal /CAS, and a write enable signal /WE applied from the external device. The command decoder 12 may generate control signals corresponding to the command CMD. The command CMD may include an active command, a read command, a write command, and a precharge command.

The address buffer 13 may receive the address ADDR applied from the external device. The address ADDR may include a word line address for addressing some of the plurality of word lines WL connected to the memory cell array 11, a bit line address for addressing some of the plurality of bit lines BL connected to the memory cell array 11, and a plate line address for addressing some of the plurality of plate electrodes PL connected to the memory cell array 11. The address buffer 13 may transmit each of the word line address, the bit line address, and the plate line address to the address decoder 14.

The address decoder 14 may include a word line decoder, a bit line decoder, and a plate line decoder for selecting the word line WL, the bit line BL, and the plate electrode PL of the memory cell MC to be accessed in response to the received address ADDR. The word line decoder may decode the word line address to activate the word line WL of the memory cell MC corresponding to the word line address. The bit line decoder may decode the bit line address to provide a bit line select signal BLS for selecting the bit line BL of the memory cell MC corresponding to the bit line address. The plate line decoder may decode the plate line address to provide a plate line select signal PLS for selecting the plate electrode PL of the memory cell MC corresponding to the plate line address.

The control circuitry 15 may control the sense amplifier 16 according to the control of the command decoder 12. The control circuitry 15 may control an operation of the sense amplifier 16 sensing the cell voltage Vcell of the memory cell MC. The control circuitry 15 may control the sense amplifier 16 to perform a precharge operation, a charge sharing operation, and a sensing operation.

The sense amplifier 16 may sense charges stored in the memory cell MC as data. In addition, the sense amplifier 16 may transmit the sensed data DQ to the data input/output circuitry 17 so that the sensed data DQ is output to the outside of the semiconductor memory device 100.

The data input/output circuitry 17 may receive the data DQ to be written in the memory cell MC from the outside and may transmit the data DQ to the memory cell array 11. The data input/output circuitry 17 may output bit data sensed by the sense amplifier 16 to the outside as read data.

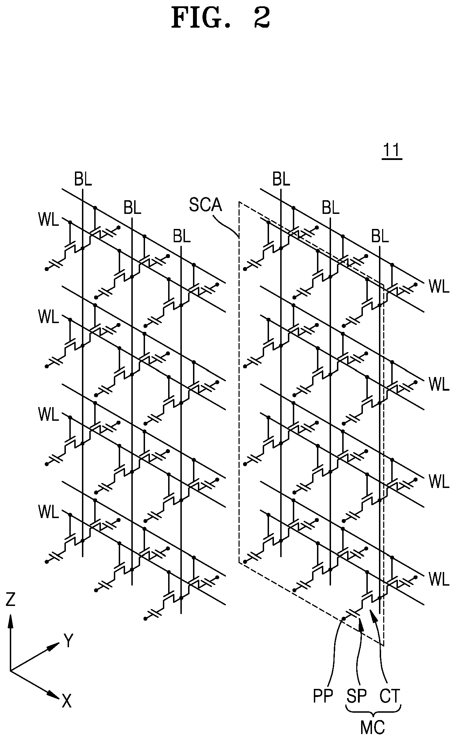

FIG. 2 is an equivalent circuit diagram illustrating a memory cell array 11 of a semiconductor memory device according to one or more embodiments.

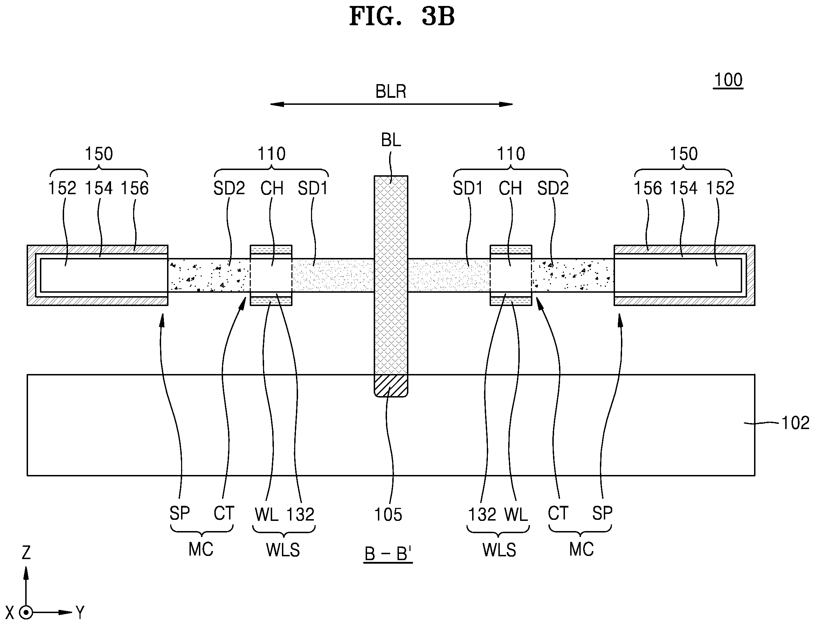

Referring to FIG. 2, the memory cell array 11 of the semiconductor memory device according to one or more embodiments may include a plurality of sub-cell arrays SCA. Each of the plurality of sub-cell arrays SCA may include a plurality of bit lines BL, a plurality of word lines WL, and a plurality of memory cells MC. Each of the plurality of memory cells MC includes a cell transistor CT and an information storage element SP. One cell transistor CT may be arranged between one word line WL and one bit line BL. The information storage element SP may be a memory element that may store data. The information storage element SP may be a memory element using a capacitor, a memory element using a magnetic tunnel junction pattern, or a memory element using a variable resistor including a phase change material. In some embodiments, the memory cell MC may be a DRAM cell, and the information storage element SP may be a capacitor, a specific example of which is described below with reference to FIG. 3B.

The word line WL may be a conductive pattern (for example, a metal line) apart from a substrate and arranged on the substrate. The plurality of word lines WL may extend in a first horizontal direction (X direction). The word lines WL in one sub-cell array SCA may be apart from one another in a vertical direction (Z direction). The bit line BL may extend from the substrate in the vertical direction (Z direction). The bit lines BL in one sub-cell array SCA may be apart from one another in the first horizontal direction (X direction).

In the memory cell array 11, the plurality of word lines WL may extend in the first horizontal direction (X direction) and may be apart from one another in a second horizontal direction (Y direction) and the vertical direction (Z direction). In the memory cell array 11, the plurality of bit lines BL may extend in the vertical direction (Z direction) and may be apart from one another in the first horizontal direction (X direction) and the second horizontal direction (Y direction). The plurality of sub-cell arrays SCA may be arranged in the second horizontal direction (Y direction). The second horizontal direction (Y direction) may be orthogonal to the first horizontal direction (X direction).

A gate of the cell transistor CT may be connected to the word line WL, and a source region of the cell transistor CT may be connected to the bit line BL. The information storage element SP may be connected to a drain region of the cell transistor CT. In some embodiments, the information storage element SP may be a capacitor including a first electrode, a second electrode, and a capacitor dielectric layer between the first electrode and the second electrode, the first electrode of the capacitor may be connected to the drain region of the cell transistor CT, and the second electrode of the capacitor may be connected to a ground wiring PP.

The memory cell array 11 of the semiconductor memory device may include the plurality of sub-cell arrays SCA including the plurality of memory cells MC apart from one another in the first horizontal direction (X direction) and the vertical direction (Z direction) and arranged in rows and columns, the plurality of bit lines BL connected to the cell transistors CT of the memory cells MC arranged in the vertical direction (Z direction), extending in the vertical direction (Z direction), and apart from one another in the first horizontal direction (X direction), and the plurality of word lines WL extending in the first horizontal direction (X direction) and apart from one another in the vertical direction (Z direction), and the plurality of sub-cell arrays SCA may be arranged in the second horizontal direction (Y direction). The semiconductor memory device may include a plurality of memory cell arrays 11.

The first horizontal direction (X direction), the second horizontal direction (Y direction), and the vertical direction (Z direction) may be referred to as a first direction, a second direction, and a third direction, respectively. Alternatively, the first horizontal direction (X direction), the vertical direction (Z direction), and the second horizontal direction (Y direction) may be referred to as a first direction, a second direction, and a third direction, respectively. The first direction, the second direction, and the third direction may be orthogonal to one another.

Two sub-cell arrays SCA adjacent to each other in the second horizontal direction (Y direction) may share the bit lines BL. Source regions of the cell transistors CT included in each of the two sub-cell arrays SCA may be connected to the bit lines BL shared by the two sub-cell arrays SCA. From each of the bit lines BL shared by the two sub-cell arrays SCA, source regions and drain regions of the cell transistors CT and the information storage elements SP of the two sub-cell arrays SCA may be arranged in opposite directions. For example, the source regions and the drain regions of the cell transistors CT and the information storage elements SP of one sub-cell array SCA connected to one bit line BL shared by the two sub-cell arrays SCA may be sequentially arranged in the second horizontal direction (Y direction), and the source regions and the drain regions of the cell transistors CT and the information storage elements SP of the other sub-cell array SCA may be arranged in a direction opposite to the second horizontal direction (Y direction). For example, two memory cells MC may be arranged in the second horizontal direction (Y direction) at the same vertical level between a pair of bit lines BL sequentially arranged to be adjacent to each other in the second horizontal direction (Y direction).

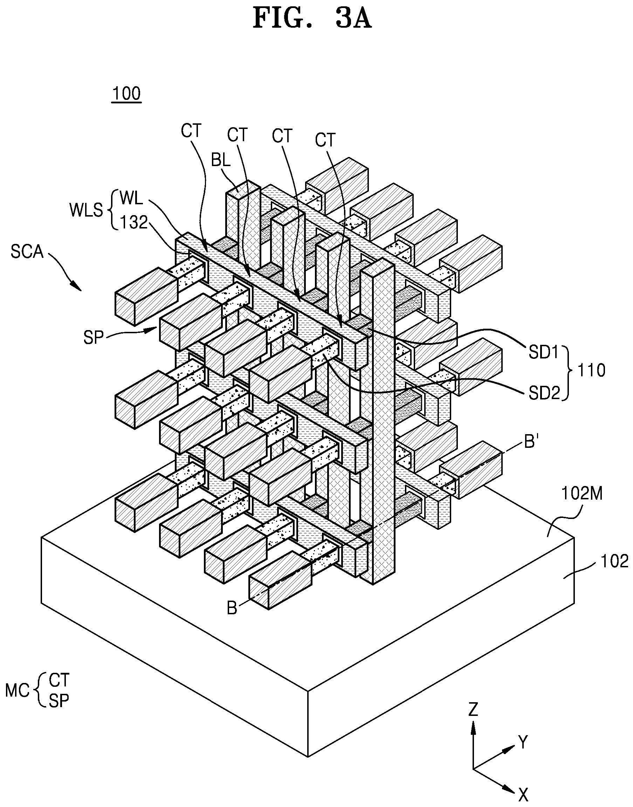

FIG. 3A is a perspective view illustrating part of a semiconductor memory device according to one or more embodiments, and FIG. 3B is a cross-sectional view illustrating part of a semiconductor memory device according to one or more embodiments. For example, FIG. 3B is a cross-sectional view taken along line B-B' of FIG. 3A.

Referring to FIGS. 3A and 3B together, the semiconductor memory device 100 includes a substrate 102 and a plurality of sub-cell arrays SCA. The plurality of sub-cell arrays SCA may be arranged in the second horizontal direction (Y direction). Each of the sub-cell array SCA may include the substrate 102, a plurality of word lines WL, a plurality of bit lines BL, a plurality of cell transistors CT, and a plurality of information storage elements SP. For example, the plurality of sub-cell arrays SCA may share the substrate 102. For example, the plurality of word lines WL may be arranged on the substrate 102 to be apart from a main surface 102M of the substrate 102. For example, the plurality of bit lines BL may extend from the main surface 102M of the substrate 102 in the vertical direction (Z direction). For example, the plurality of cell transistors CT may be arranged between the plurality of word lines WL and the plurality of bit lines BL, and the plurality of information storage elements SP may be connected to the plurality of cell transistors CT. The plurality of cell transistors CT and the plurality of information storage elements SP may constitute a plurality of memory cells MC.

The plurality of word lines WL may extend in the first horizontal direction (X direction) on the substrate 102 and may be apart from one another in the second horizontal direction (Y direction) and the vertical direction (Z direction). For example, a first word line WL may extend in the first horizontal direction (X direction) on the substrate 102 and may be spaced apart from a second word line WL in the second horizontal direction (Y direction) and spaced apart from a third word line WL in the vertical direction (Z direction). The plurality of bit lines BL may extend from the substrate 102 in the vertical direction (Z direction) and may be apart from one another in the first horizontal direction (X direction). Although it is illustrated in FIG. 3A that the plurality of bit lines BL are apart from one another in the first horizontal direction (X direction) and extend in the vertical direction (Z direction), as illustrated in FIG. 2, the plurality of bit lines BL may be apart from one another in the first horizontal direction (X direction) and the second horizontal direction (Y direction) and may extend in the vertical direction (Z direction).

According to an embodiment, one cell transistor CT may be arranged between one word line WL and one bit line BL. The information storage element SP may be connected to the cell transistor CT. The cell transistors CT and the information storage elements SP may be sequentially arranged in the second horizontal direction (Y direction) or the direction opposite to the second horizontal direction (Y direction) from the bit line BL to which the cell transistors CT are connected.

The word line WL may be adjacent to a semiconductor pattern 110. In some embodiments, the word line WL may surround the semiconductor pattern 110. A gate dielectric layer 132 may be between the word line WL and the semiconductor pattern 110. The word line WL and the gate dielectric layer 132 may constitute a word line structure WLS. The semiconductor pattern 110 and the word line structure WLS may constitute the cell transistor CT.

The semiconductor pattern 110 may include a source region SD1, a drain region SD2, and a channel region CH between the source region SD1 and the drain region SD2. The source region SD1 may be connected to the bit line BL, and the drain region SD2 may be connected to the information storage element SP. The source region SD1 may be referred to as a direct contact, and the drain region SD2 may be referred to as a buried contact.

The source region SD1, the channel region CH, and the drain region SD2 may be sequentially arranged in the second horizontal direction (Y direction) or a direction opposite to the second horizontal direction (Y direction) from the bit line BL. For example, two sub-cell arrays SCA adjacent to each other in the second horizontal direction (Y direction) may share the bit lines BL. The source regions SD1 of the cell transistors CT included in each of the two sub-cell arrays SCA may be connected to the bit lines BL shared by the two sub-cell arrays SCA. From each of the bit lines BL shared by the two sub-cell arrays SCA, the source regions SD1, the channel regions CH, and the drain regions SD2 of the cell transistors CT and the information storage elements SP of the two sub-cell arrays SCA may be arranged in opposite directions. For example, the source regions SD1, the channel regions CH, and the drain regions SD2 of the cell transistors CT and the information storage elements SP of one sub-cell array SCA connected to one bit line BL shared by the two sub-cell arrays SCA may be sequentially arranged in the second horizontal direction (Y direction), and the source regions SD1, the channel regions CH, and the drain regions SD2 of the cell transistors CT and the information storage elements SP of the other sub-cell array SCA may be arranged in a direction opposite to the second horizontal direction (Y direction). For example, two memory cells MC may be arranged in the second horizontal direction (Y direction) at the same vertical level between a pair of bit lines BL sequentially arranged to be adjacent to each other in the second horizontal direction (Y direction).

The semiconductor pattern 110 and the word line WL corresponding to each other may partially overlap each other in the vertical direction (Z direction). For example, the semiconductor pattern 110 and the word line WL corresponding to each other may partially overlap each other in the vertical direction (Z direction). In some embodiments, the semiconductor pattern 110 may extend in the second horizontal direction (Y direction) through the word line WL. The channel region CH may include at least part of a portion of the semiconductor pattern 110 overlapping the word line WL in the vertical direction (Z direction). In some embodiments, the channel region CH may include at least part of a portion of the semiconductor pattern 110 passing through the word line WL. For example, the channel region CH may include a portion of the semiconductor pattern 110 overlapping the word line WL in the vertical direction (Z direction). In some embodiments, the channel region CH may include a portion of the semiconductor pattern 110 passing through the word line WL. A length of the channel region CH in the second horizontal direction (Y direction) may be equal to a length of the word line WL in the second horizontal direction (Y direction). A length of the source region SD1 in the second horizontal direction (Y direction) may be equal to a distance between the word line WL and the bit line BL in the second horizontal direction (Y direction).

According to some embodiments, the source region SD1 and the drain region SD2 of the semiconductor pattern 110 may be doped with a first impurity, and the channel region CH may be doped with a second impurity different from the first impurity. For example, based on the first impurity, the source region SD1 and the drain region SD2 may have a first conductivity type, and based on the second impurity, the channel region CH may have a second conductivity type different from the first conductivity type. For example, the first impurity may cause each of the source region SD1 and the drain region SD2 to have a first conductivity type, and the second impurity may cause the channel region CH to have a second conductivity type different from the first conductivity type. In some embodiments, the first conductivity type may be n-type and the second conductivity type may be p-type. However, the disclosure is not limited thereto. For example, the first conductivity type may be p-type and the second conductivity type may be n-type. In an example case in which the first conductivity type is n-type, the first impurity may include, but is not limited to, phosphorus (P), arsenic (As), or antimony (Sb), and in an example case in which the second conductivity type is p-type, the second impurity may include, but is not limited to, boron (B), aluminum (Al), gallium (Ga), or indium (In). For example, the source region SD1 and the drain region SD2 of the semiconductor pattern 110 may be doped with P impurities.

The word line WL may surround part of the semiconductor pattern 110 with the gate dielectric layer 132 between the word line WL and the semiconductor pattern 110. For example, the gate dielectric layer 132 may be provided on a top surface, a bottom surface, and a first side surface and a second side surface in the first horizontal direction (X direction) of the semiconductor pattern 110, and the word line WL may be provided on a top surface, a bottom surface, and a first side surface and a second side surface in the first horizontal direction (X direction) of the gate dielectric layer 132. For example, the gate dielectric layer 132 may cover a top surface, a bottom surface, and both sides in the first horizontal direction (X direction) of part of the semiconductor pattern 110, and the word line WL may cover the gate dielectric layer 132 covering the top surface, the bottom surface, and both sides in the first horizontal direction (X direction) of part of the semiconductor pattern 110.

The bit line BL may include a metal. For example, the bit line BL may include a metal including, but not limited to, titanium (Ti), tantalum (Ta), molybdenum (Mo), ruthenium (Ru), tungsten (W), cobalt (Co), aluminum (Al), or nickel (Ni), conductive metal nitride such as TiN, TaN, WN, RuTiN, TiSiN, WSiN, or TaSiN, metal silicide such as TiSi, WSi, TaSi, CoSi, or NiSi, or a combination thereof. However, the disclosure is not limited thereto.

An isolation insulating layer 105 may be between the substrate 102 and the bit line BL. The bit line BL may be positioned on the isolation insulating layer 105. The semiconductor memory device 100 may include a plurality of isolation insulating layers 105 corresponding to the plurality of bit lines BL. A width of the bit line BL in the second horizontal direction (Y direction) may be equal to or substantially equal to a width of the isolation insulating layer 105 in the second horizontal direction (Y direction). For example, bottom surface of the bit line BL may be provided on the isolation insulating layer 105. For example, the isolation insulating layer 105 may be covered with a bottom surface of the bit line BL. The bit line BL may be apart from the substrate 102 with the isolation insulating layer 105 between the bit line BL and the substrate 102. The isolation insulating layer 105 may electrically insulate the substrate 102 from the bit line BL. At least part of the isolation insulating layer 105 may be buried in the substrate 102. The isolation insulating layer 105 may be apart from the semiconductor pattern 110. For example, a top surface of the isolation insulating layer 105 may be at a vertical level lower than a bottom surface of the lowermost semiconductor pattern 110. The top surface of the isolation insulating layer 105 may be at a vertical level equal to or higher than a top surface of the substrate 102. In some embodiments, the isolation insulating layer 105 may include an insulating material including impurities. The impurities included in the isolation insulating layer 105 and the impurities included in the source region SD1 may be the same. For example, the isolation insulating layer 105 may include the first impurity. In some embodiments, the isolation insulating layer 105 may include phosphorus silicate glass (PSG) or boron silicate glass (BSG). In an example case in which the source region SD1 has n-type as the first conductivity type, the isolation insulating layer 105 may include PSG. In an example case in which the source region SD1 has p-type as the first conductivity type, the isolation insulating layer 105 may include BSG.

In some embodiments, the information storage element SP may be a capacitor structure 150 including a first electrode 152, a second electrode 156, and a capacitor dielectric layer 154 between the first electrode 152 and the second electrode 156. The capacitor structure 150 may include the first electrode 152 connected to the drain region SD2 of the semiconductor pattern 110 and extending in the second horizontal direction (Y direction). For example, the capacitor dielectric layer 154 may be provided on the first electrode 152, and the second electrode 156 may be provided on the capacitor dielectric layer 154. For example, the capacitor dielectric layer 154 may cover the first electrode 152, and the second electrode 156 may cover the capacitor dielectric layer 154. The second electrode 156 may be connected to the ground wiring PP illustrated in FIG. 2 or may include part of the ground wiring PP. The first electrode 152 and the second electrode 156 may be referred to as a lower electrode and an upper electrode, respectively. The capacitor dielectric layer 154 may be between the first electrode 152 and the second electrode 156.

The first electrode 152 may include a metal, conductive metal nitride, conductive metal silicide, or a combination thereof. In some embodiments, the first electrode 152 may include a high-melting point metal layer such as Co, Ti, Ni, W, or Mo. For example, the first electrode 152 may include a metal nitride layer such as a titanium nitride layer, a titanium silicon nitride layer, a titanium aluminum nitride layer, a tantalum nitride layer, a tantalum silicon nitride layer, a tantalum aluminum nitride layer, or a tungsten nitride layer.

The capacitor dielectric layer 154 may include at least one selected from a high-k dielectric material having a higher dielectric constant than silicon oxide and a ferroelectric material. For example, the capacitor dielectric layer 154 may include at least one of metal oxide and a perovskite structure dielectric material. In some embodiments, the capacitor dielectric layer 154 includes at least one selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO).

The second electrode 156 may include, but is not limited to, doped silicon, Ru, RuO, Pt, PtO, Ir, IrO, SRO(SrRuO), BSRO((Ba,Sr)RuO), CRO(CaRuO), BaRuO, La(Sr,Co)O, Ti, TiN, W, WN, Ta, TaN, TiAlN, TiSiN, TaAlN, TaSiN, or a combination thereof. In some embodiments, the second electrode 156 may include W. Although it is illustrated in FIGS. 3 to 4C that the plurality of information storage elements SP are apart from one another, the disclosure is not limited thereto. In an example case in which the plurality of information storage elements SP are the plurality of capacitor structures 150, each two of the plurality of second electrodes 156 of the plurality of capacitor structures 150 included in the sub-cell arrays SCA may be connected to each other to be integrated with each other. In an example case in which the plurality of information storage elements SP are the plurality of capacitor structures 150 and each two of the plurality of capacitor structures 150 included in a pair of sub-cell arrays SCA adjacent to each other in the second horizontal direction (Y direction) face each other and are adjacent to each other, each two of the plurality of second electrodes 156 of the plurality of capacitor structures 150 included in the pair of sub-cell arrays SCA may be connected to each other to be integrated with each other.

The semiconductor memory device 100 according to the disclosure has a low resistance because the plurality of bit lines BL include a metal, and the isolation insulating layer 105 is interposed between each of the plurality of bit lines BL and the substrate 102 to prevent the substrate 102 from functioning as a bridge connecting the bit lines BL. Therefore, electrical reliability of the semiconductor memory device 100 may be improved.

In addition, because the isolation insulating layer 105 and the source region SD1 include the same impurities, the isolation insulating layer 105 may be used to dope the source region SD1 with impurities, and the isolation insulating layer 105 used to dope the source region SD1 with impurities may be between each of the plurality of bit lines BL and the substrate 102, thereby simplifying a method of manufacturing the semiconductor memory device 100 and reducing costs.

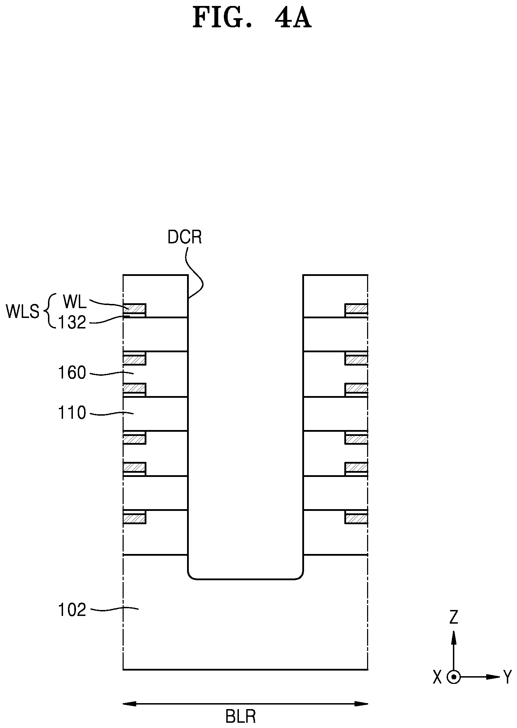

FIGS. 4A to 4E are cross-sectional views illustrating a method of manufacturing a semiconductor memory device according to one or more embodiments, FIGS. 4A to 4E are cross-sectional views illustrating a portion corresponding to a region BLR of FIG. 3B.

Referring to FIG. 4A, according to an embodiment, the method may include forming a substrate 102 and a plurality of semiconductor patterns 110 on the substrate 102. For example, the substrate 102 and the plurality of semiconductor patterns 110 apart from one another in the vertical direction (Z direction) on the substrate 102 and extending in the second horizontal direction (Y direction) are formed. The plurality of semiconductor patterns 110 may be apart from the substrate 102. The method may include forming interlayer insulating layers 160 between the substrate 102 and the lowermost semiconductor pattern 110 and between each pair of semiconductor patterns 110 adjacent to each other in the vertical direction (Z direction). For example, a plurality of interlayer insulating layers 160 and the plurality of semiconductor patterns 110 may be alternately arranged on the substrate 102 in the vertical direction (Z direction).

For example, the substrate 102 may include silicon (Si), for example, monocrystalline Si, polycrystalline Si, or amorphous Si. However, the disclosure is not limited thereto, and as such, according to another embodiment, the substrate 102 may include at least one semiconductor selected from a semiconductor element such as germanium (Ge), silicon germanium (SiGe), silicon carbide (SiC), gallium arsenide (GaAs), indium arsenide (InAs), and indium phosphide (InP). According to another embodiment, the substrate 102 may include a silicon-on-insulator (SOI) substrate or a germanium-on-insulator (GeOI) substrate. For example, the substrate 102 may include a buried oxide (BOX) layer. The substrate 102 may include a conductive region, for example, an impurity-doped well or an impurity-doped structure.

In some embodiments, the semiconductor pattern 110 may include a material having the same or similar etching characteristics as the substrate 102. In some embodiments, the semiconductor pattern 110 may include a same material as the substrate 102. In some embodiments, the semiconductor pattern 110 may include Si. In some embodiments, the semiconductor pattern 110 may include a single crystal semiconductor material. For example, the semiconductor pattern 110 may include single crystal Si. In some embodiments, the semiconductor pattern 110 may include a 2D semiconductor material or an oxide semiconductor material. For example, the 2D semiconductor material may include MoS₂, WSe₂, graphene, carbon nanotube, or a combination thereof. For example, the oxide semiconductor material may include InₓGa_{y}Zn_{z}O, InₓGaySi_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or a combination thereof. For example, the semiconductor pattern 110 may include a single layer or a multilayer of the oxide semiconductor material. In some embodiments, the semiconductor pattern 110 may be formed of a material having a band gap energy greater than that of silicon. For example, the semiconductor pattern 110 may include a material having a band gap energy of about 1.5 eV to 5.6 eV. For example, the semiconductor pattern 110 may include a material that may have optimal channel performance when the material has a band gap energy of about 2.0 eV to 4.0 eV.

For example, the interlayer insulating layer 160 may include an insulating material. The insulating material may include, but is not limited to, silicon oxide, silicon nitride, a low-k dielectric material, or a combination thereof. The low-k dielectric material having a lower dielectric constant than silicon oxide may include, but is not limited to, phosphosilicate glass (PSG), borophosphosilicate glass (BPSG), fluorosilicate glass (FSG), organosilicate glass (OSG), spin-on-glass (SOG), spin-on-polymer, or a combination thereof. In some embodiments, the interlayer insulating layer 160 may include an ultra low-k (ULK) dielectric layer having an ultra low dielectric constant K of about 2.2 to about 2.4. The ULK dielectric layer may include SiOC or SiCOH.

The word line structure WLS may surround part of the semiconductor pattern 110. The word line structure WLS includes the gate dielectric layer 132 and the word line WL. The interlayer insulating layer 160 may be between the word lines WL adjacent to each other in the vertical direction (Z direction).

In some embodiments, the word line WL may include a conductive barrier layer on the gate dielectric layer 132 and a conductive filling layer on the conductive barrier layer. For example, the word line WL may include a conductive barrier layer covering the gate dielectric layer 132 and a conductive filling layer covering the conductive barrier layer. The conductive barrier layer may include, but is not limited to, metal, conductive metal nitride, conductive metal silicide, or a combination thereof. For example, the conductive barrier layer may include TiN. The conductive filling layer may include, but is not limited to, doped silicon, Ru, RuO, Pt, PtO, Ir, IrO, SRO(SrRuO), BSRO((Ba,Sr)RuO), CRO(CaRuO), BaRuO, La(Sr,Co)O, Ti, TiN, W, WN, Ta, TaN, TiAlN, TiSiN, TaAlN, TaSiN, or a combination thereof. In some embodiments, the conductive filling layer may include W.

The gate dielectric layer 132 may include, but is not limited to, at least one selected from silicon oxide, a high-k dielectric material having a higher dielectric constant than silicon oxide, and a ferroelectric material. In some embodiments, the gate dielectric layer 132 may have a stacked structure of a first dielectric layer including silicon oxide and a second dielectric layer including at least one selected from a high-k dielectric material and a ferroelectric material. For example, the high-k dielectric material and the ferroelectric material may include, but is not limited to, at least one selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), or lead scandium tantalum oxide (PbScTaO).

According to an embodiment, the method may include forming an isolation recess DCR extending into the substrate 102. For example, the isolation recess DCR extending into the substrate 102 may be formed through a stacked structure of the plurality of interlayer insulating layers 160 and the plurality of semiconductor patterns 110. The isolation recess DCR may be formed by removing part of each of the plurality of interlayer insulating layers 160 and the plurality of semiconductor patterns 110 and part of the substrate 102. The isolation recess DCR may be apart from a plurality of word line structures WLS. For example, the plurality of interlayer insulating layers 160 may be between the isolation recess DCR and the plurality of word line structures WLS. Part of the substrate 102 may be exposed on a bottom surface of the isolation recess DCR, and side surfaces of the plurality of semiconductor patterns 110 and the plurality of interlayer insulating layers 160 may be exposed on an internal surface of the isolation recess DCR. The lowermost end of the isolation recess DCR may be at a vertical level lower than the top surface of the substrate 102.

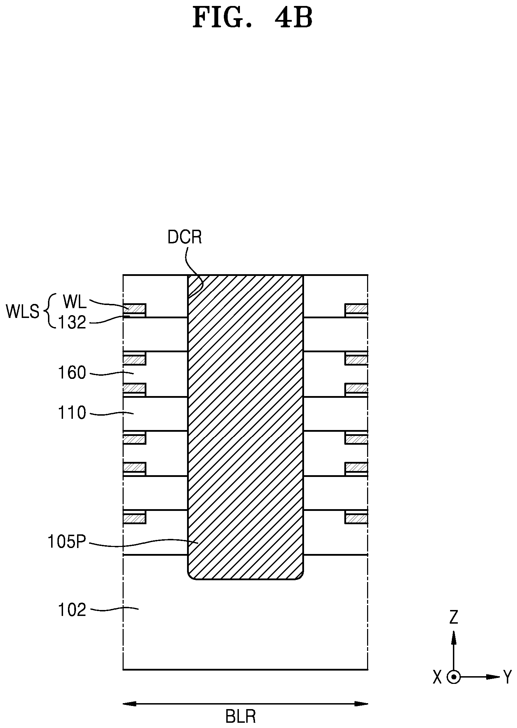

Referring to FIG. 4B, according to an embodiment, the method may include filling the isolation recess DCR with an isolation insulating material layer 105P. The isolation insulating material layer 105P may include an insulating material including impurities. The isolation insulating material layer 105P may contact a surface of the substrate 102 and the side surfaces of the plurality of semiconductor patterns 110. The isolation insulating material layer 105P may fill an entire portion of the isolation recess DCR extending into the substrate 102. The isolation insulating material layer 105P may be provided on the plurality of semiconductor patterns 110 exposed in the isolation recess DCR. For example, the isolation insulating material layer 105P may be provided on all surfaces of the plurality of semiconductor patterns 110 exposed in the isolation recess DCR. For example, the isolation insulating material layer 105P may cover all surfaces of the plurality of semiconductor patterns 110 exposed in the isolation recess DCR. In some embodiments, the isolation insulating material layer 105P may include PSG or BSG. For example, the isolation insulating material layer 105P may include PSG.

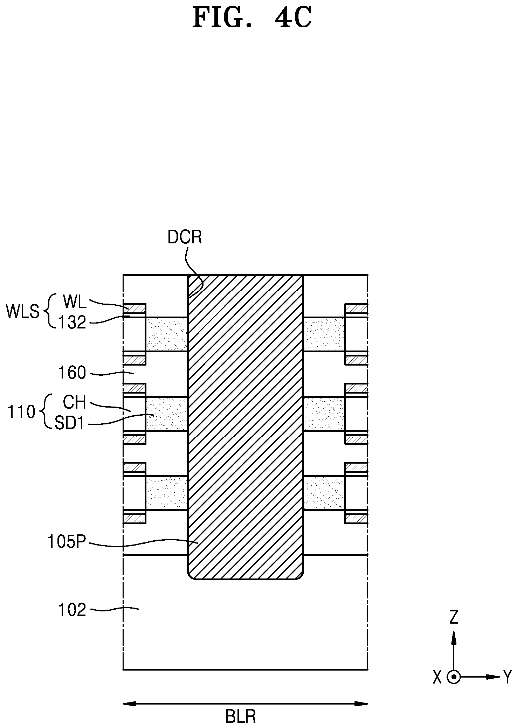

Referring to FIG. 4C, according to an embodiment, the method may include performing a heat treatment to form the source region SD1. For example, the heat treatment may be performed to diffuse impurities included in the isolation insulating material layer 105P into each of the plurality of semiconductor patterns 110 to form the source region SD1 in part of each the plurality of semiconductor patterns 110 adjacent to the isolation insulating material layer 105P. A portion of the semiconductor pattern 110 adjacent to the source region SD1 and at least partially surrounded by the word line structure WLS may remain as the channel region CH.

In an example case in which the isolation insulating material layer 105P includes PSG, P as an impurity included in the isolation insulating material layer 105P may be diffused into each of the plurality of semiconductor patterns 110 to form the source region SD1 in a portion of each of the plurality of semiconductor patterns 110 adjacent to the isolation insulating material layer 105P.

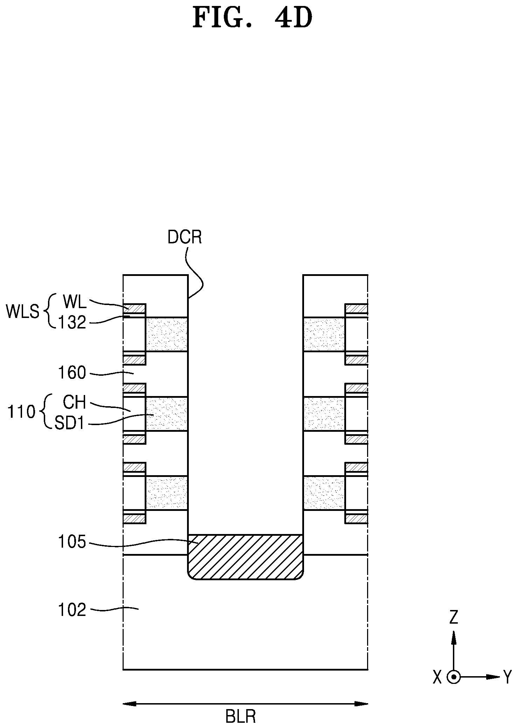

Referring to FIGS. 4C and 4D together, according to an embodiment, the method may include removing a part of an upper side of the isolation insulating material layer 105P to form the isolation insulating layer 105. At least part of the isolation insulating layer 105 may be buried in the substrate 102. The isolation insulating layer 105 may be apart from the semiconductor pattern 110. The isolation insulating layer 105 may be formed by removing at least part of a portion of the isolation insulating material layer 105P at a vertical level higher than the top surface of the substrate 102. For example, the top surface of the isolation insulating layer 105 may be at a vertical level lower than the bottom surface of the lowermost semiconductor pattern 110, but may be at a vertical level equal to or higher than the top surface of the substrate 102. In some embodiments, the top surface of the isolation insulating layer 105 may be at a vertical level lower than the bottom surface of the lowermost semiconductor pattern 110, but may be at a vertical level higher than the top surface of the substrate 102. The isolation insulating layer 105 may fill an entire portion of the isolation recess DCR extending into the substrate 102.

The isolation insulating layer 105 may include an insulating material including impurities. The impurities included in the isolation insulating layer 105 and the impurities included in the source region SD1 may be the same. In an example case in which the isolation insulating layer 105 includes PSG, the source region SD1 may include P as an impurity and may have an n-type conductivity type.

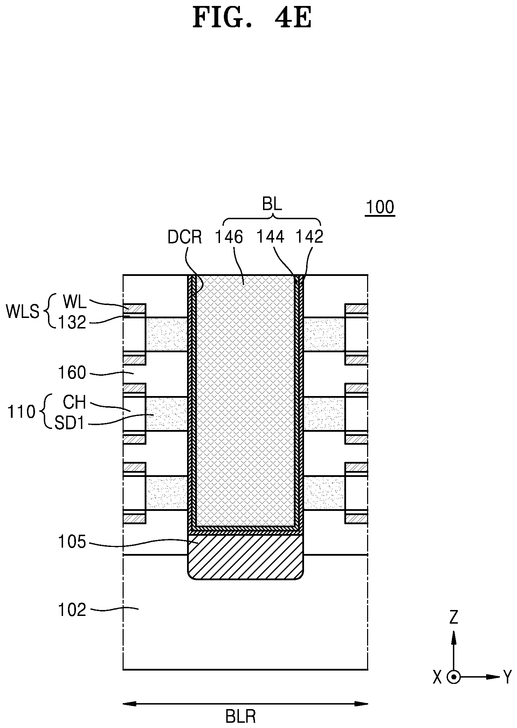

Referring to FIG. 4E, according to an embodiment, the method may include forming a bit line BL by filling in the isolation recess DCR on the isolation insulating layer 105. For example, the semiconductor memory device 100 is formed by the bit line BL filling the isolation recess DCR on the isolation insulating layer 105. The bit line BL may include a metal. For example, the bit line BL may include a metal such as Ti, Ta, Mo, Ru, W, Co, Al, or Ni, conductive metal nitride such as TiN, TaN, WN, RuTiN, TiSiN, WSiN, or TaSiN, metal silicide such as TiSi, WSi, TaSi, CoSi, or NiSi, or a combination thereof. However, the disclosure is not limited thereto.

In some embodiments, the bit line BL may include a metal silicide layer 142 contacting one end of each of the plurality of semiconductor patterns 110, for example, the source regions SD1, a conductive barrier layer 144 on the metal silicide layer 142, and a conductive filling layer 146 on the conductive barrier layer 144. For example, the conductive barrier layer 144 may cover the metal silicide layer 142, and the conductive filling layer 146 may cover the conductive barrier layer 144. According to an embodiment illustrated in FIG. 4E, the metal silicide layer 142 may be provided on surfaces of the plurality of interlayer insulating layers 160 and the plurality of semiconductor patterns 110 exposed to the internal surface of the isolation recess DCR on the isolation insulating layer 105 and the top surface of the isolation insulating layer 105. For example, the metal silicide layer 142 covers surfaces of the plurality of interlayer insulating layers 160 and the plurality of semiconductor patterns 110 exposed to the internal surface of the isolation recess DCR on the isolation insulating layer 105 and the top surface of the isolation insulating layer 105. However, the disclosure is not limited thereto. In some embodiments, the metal silicide layer 142 may be provided on the surfaces of the plurality of semiconductor patterns 110 exposed to the internal surface of the isolation recess DCR, but the metal silicide layer 142 may not be provided on the surfaces of the plurality of interlayer insulating layers 160 exposed to the internal surface of the isolation recess DCR and the top surface of the isolation insulating layer 105. For example, the metal silicide layer 142 may cover the surfaces of the plurality of semiconductor patterns 110 exposed to the internal surface of the isolation recess DCR, but may not cover the surfaces of the plurality of interlayer insulating layers 160 exposed to the internal surface of the isolation recess DCR and the top surface of the isolation insulating layer 105. For example, the metal silicide layer 142 may include, but is not limited to, molybdenum silicide or titanium silicide.

In some embodiments, the metal silicide layer 142 may be omitted. For example, the bit line BL may include the conductive barrier layer 144 contacting one end of each of the plurality of semiconductor patterns 110, for example, the source regions SD1 and a conductive filling layer 146 on the conductive barrier layer 144. For example, a conductive filling layer 146 may cover the conductive barrier layer 144. For example, the conductive barrier layer 144 may include metal or conductive metal nitride. For example, the conductive barrier layer 144 may include TiN. For example, the conductive filling layer 146 may include, but is not limited to, Ru, RuO, Pt, PtO, Ir, IrO, SRO(SrRuO), BSRO((Ba,Sr)RuO), CRO(CaRuO), BaRuO, La(Sr,Co)O, Ti, TiN, W, WN, Ta, TaN, TiAlN, TiSiN, TaAlN, TaSiN, or a combination thereof. In some embodiments, the conductive filling layer 146 may include W.

Referring to FIGS. 4A to 4E together, the semiconductor memory device 100 according to the disclosure has a low resistance because the plurality of bit lines BL include a metal, and the isolation insulating layer 105 is interposed between each of the plurality of bit lines BL and the substrate 102 to prevent the substrate 102 from functioning as a bridge connecting the bit lines BL. Therefore, electrical reliability of the semiconductor memory device 100 may be improved. In addition, since the source region SD1 may be doped with impurities by using the isolation insulating material layer 105P, and since the isolation insulating layer 105 as part of the isolation insulating material layer 105P used to dope the source region SD1 with impurities insulates the bit line BL from the substrate 102, the method of manufacturing the semiconductor memory device 100 may be simplified and costs may be reduced.

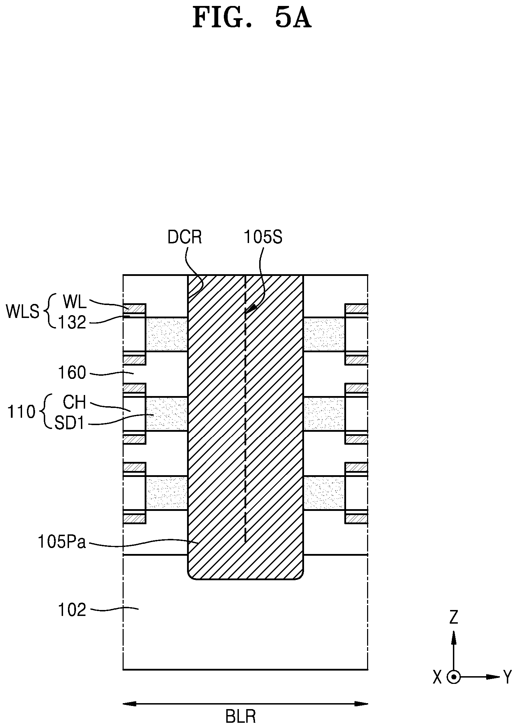

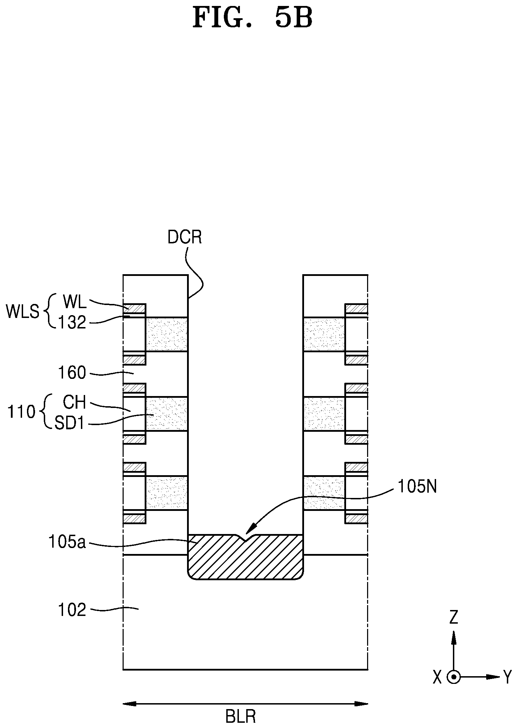

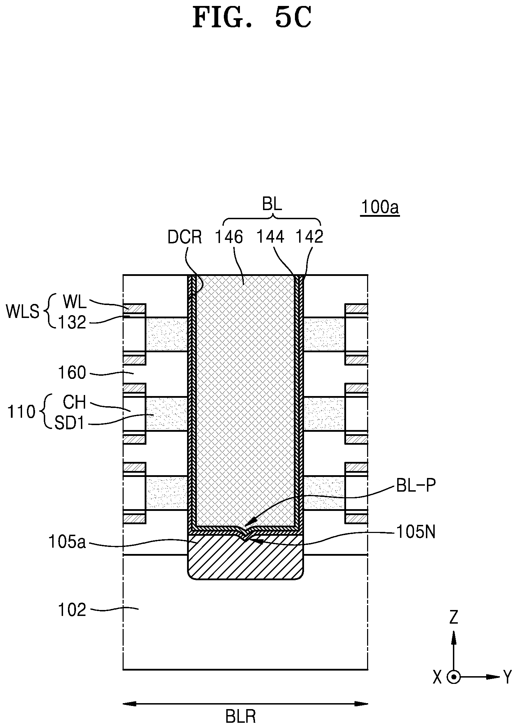

FIGS. 5A and 5B are cross-sectional views illustrating a method of manufacturing a semiconductor memory device according to one or more embodiments, and FIG. 5C is a cross-sectional view illustrating a semiconductor memory device according to one or more embodiments.

Referring to FIG. 5A, according to an embodiment, the method may include forming an isolation insulating material layer 105Pa in the isolation recess DCR. For example, the isolation insulating material layer 105Pa may be formed by filling the isolation recess DCR formed in FIG. 4A. The isolation insulating material layer 105Pa may include an insulating material including impurities. The isolation insulating material layer 105Pa may contact a surface of the substrate 102 and the side surfaces of the plurality of semiconductor patterns 110. The isolation insulating material layer 105Pa may fill an entire portion of the isolation recess DCR extending into the substrate 102. The isolation insulating material layer 105Pa may be provided on surfaces of the plurality of semiconductor patterns 110 exposed in the isolation recess DCR. For example, the isolation insulating material layer 105Pa may cover all surfaces of the plurality of semiconductor patterns 110 exposed in the isolation recess DCR. In some embodiments, the isolation insulating material layer 105Pa may include PSG or BSG. For example, the isolation insulating material layer 105Pa may include PSG.

The isolation insulating material layer 105Pa may have a seam 105S extending inward from a top surface thereof. The seam 105S of the isolation insulating material layer 105Pa may extend inward from the top surface thereof, but may not extend to a bottom surface thereof.

A heat treatment is performed to diffuse impurities included in the isolation insulating material layer 105Pa into each of the plurality of semiconductor patterns 110 to form the source region SD1 in part of each the plurality of semiconductor patterns 110 adjacent to the isolation insulating material layer 105Pa. In an example case in which the isolation insulating material layer 105Pa includes PSG, P as an impurity included in the isolation insulating material layer 105Pa may be diffused into each of the plurality of semiconductor patterns 110 to form the source region SD1 in a portion of each of the plurality of semiconductor patterns 110 adjacent to the isolation insulating material layer 105Pa.

Referring to FIGS. 5A and 5B together, according to an embodiment, the method may include removing a part of an upper side of the isolation insulating material layer 105Pa to form the isolation insulating layer 105a. At least part of the isolation insulating layer 105a may be buried in the substrate 102a. The isolation insulating layer 105a may be apart from the semiconductor pattern 110. The isolation insulating layer 105a may be formed by removing part of the isolation insulating material layer 105Pa at a vertical level higher than a top surface of the substrate 102. For example, the top surface of the isolation insulating layer 105a may be at a vertical level lower than the bottom surface of the lowermost semiconductor pattern 110, but may be at a vertical level equal to or higher than the top surface of the substrate 102. In some embodiments, the top surface of the isolation insulating layer 105a may be at a vertical level lower than the bottom surface of the lowermost semiconductor pattern 110, but may be at a vertical level higher than the top surface of the substrate 102. For example, part of the isolation insulating layer 105a may be buried in the substrate 102, and the remaining part of the isolation insulating layer 105a may protrude from the top surface of the substrate 102. The isolation insulating layer 105a may fill an entire portion of the isolation recess DCR extending into the substrate 102.

The isolation insulating layer 105a may include an insulating material including impurities. The impurities included in the isolation insulating layer 105a and the impurities included in the source region SD1 may be the same.

The isolation insulating layer 105a may have a groove 105N in a top surface thereof. The groove 105N of the isolation insulating layer 105a may be formed at a position corresponding to the seam 105S of the isolation insulating material layer 105Pa. The groove 105N of the isolation insulating layer 105a may have a notch shape extending inward from the uppermost end of the isolation insulating layer 105a.

Referring to FIG. 5C, according to an embodiment, the method may include forming a bit line BL by filling in the isolation recess DCR on the isolation insulating layer 105a. For example, the semiconductor memory device 100a is formed by forming a bit line BL filling the isolation recess DCR on the isolation insulating layer 105a. The bit line BL may fill the groove 105N of the isolation insulating layer 105a. A portion of the bit line BL filling the groove 105N of the isolation insulating layer 105a may be referred to as a protrusion BL-P of the bit line BL. The protrusion BL-P may extend from the bottom surface of the bit line BL into the isolation insulating layer 105a.

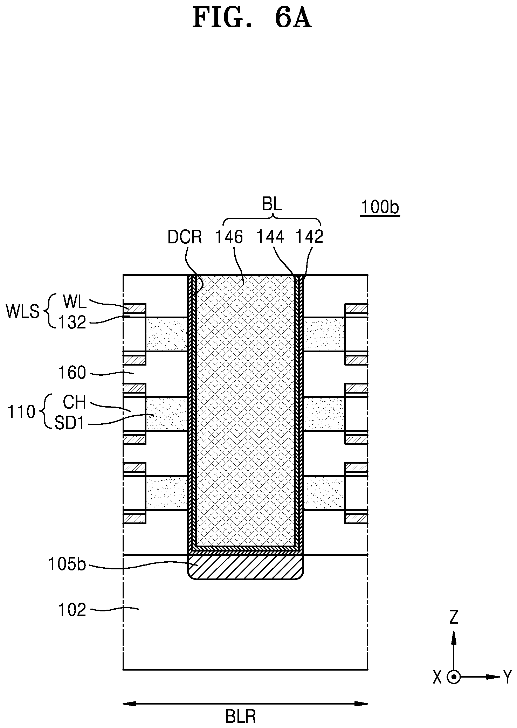

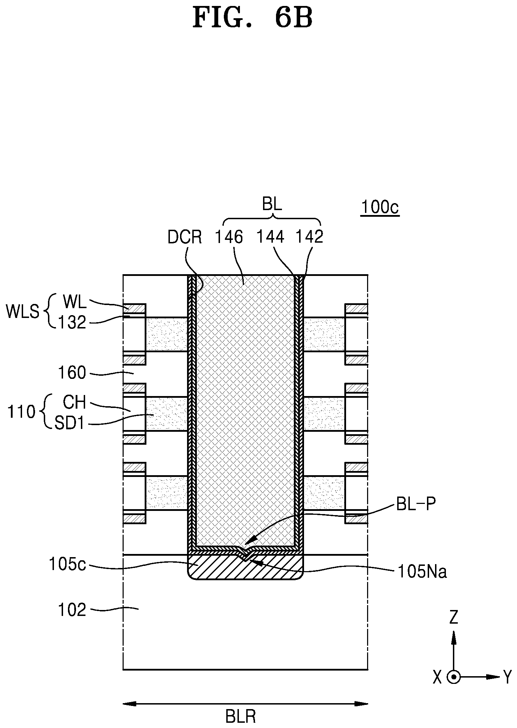

FIGS. 6A and 6B are cross-sectional views illustrating semiconductor memory devices 100b and 100c according to one or more embodiments.

Referring to FIG. 6A, the semiconductor memory device 100b may include an isolation insulating layer 105b between the substrate 102 and the bit line BL. The bit line BL may be apart from the substrate 102 with the isolation insulating layer 105b between the bit line BL and the substrate 102. The isolation insulating layer 105b may electrically insulate the substrate 102 from the bit line BL. The isolation insulating layer 105b may be buried in the substrate 102. The isolation insulating layer 105b may be apart from the semiconductor pattern 110. For example, a top surface of the isolation insulating layer 105b may be at a vertical level lower than a bottom surface of the lowermost semiconductor pattern 110. The top surface of the isolation insulating layer 105b may be at a vertical level equal to a top surface of the substrate 102.

Referring to FIG. 6B, the semiconductor memory device 100c may include an isolation insulating layer 105c between the substrate 102 and the bit line BL. The bit line BL may be apart from the substrate 102 with the isolation insulating layer 105c between the bit line BL and the substrate 102. The isolation insulating layer 105c may electrically insulate the substrate 102 from the bit line BL. The isolation insulating layer 105c may be buried in the substrate 102. The isolation insulating layer 105c may be apart from the semiconductor pattern 110. For example, a top surface of the isolation insulating layer 105c may be at a vertical level lower than a bottom surface of the lowermost semiconductor pattern 110. The top surface of the isolation insulating layer 105c may be at a vertical level equal to a top surface of the substrate 102.

The isolation insulating layer 105c may have a groove 105Na in a top surface thereof. The groove 105Na of the isolation insulating layer 105c may have a notch shape extending inward from the uppermost end of the isolation insulating layer 105c. The bit line BL may fill the groove 105Na of the isolation insulating layer 105c. A portion of the bit line BL filling the groove 105Na of the isolation insulating layer 105c may be referred to as a protrusion BL-P of the bit line BL. The protrusion BL-P may extend from the bottom surface of the bit line BL into the isolation insulating layer 105c.

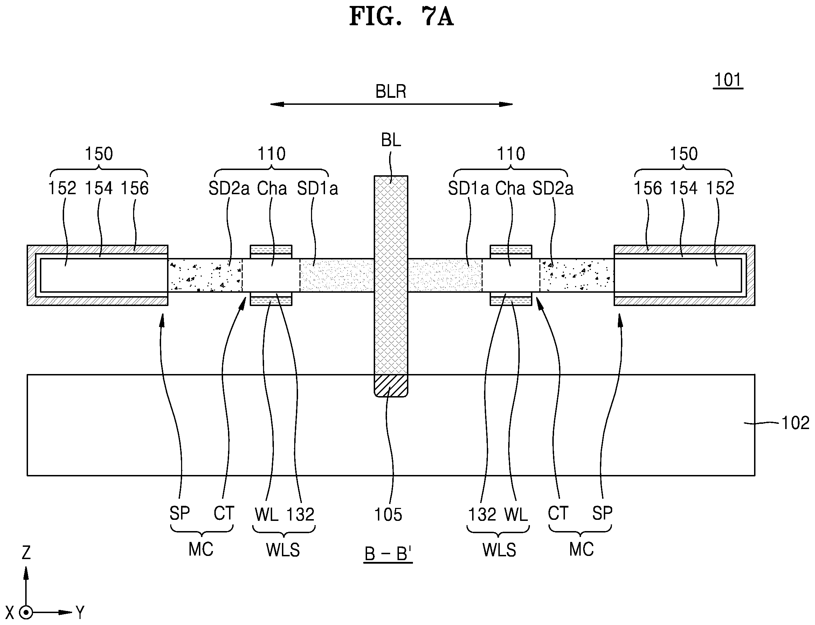

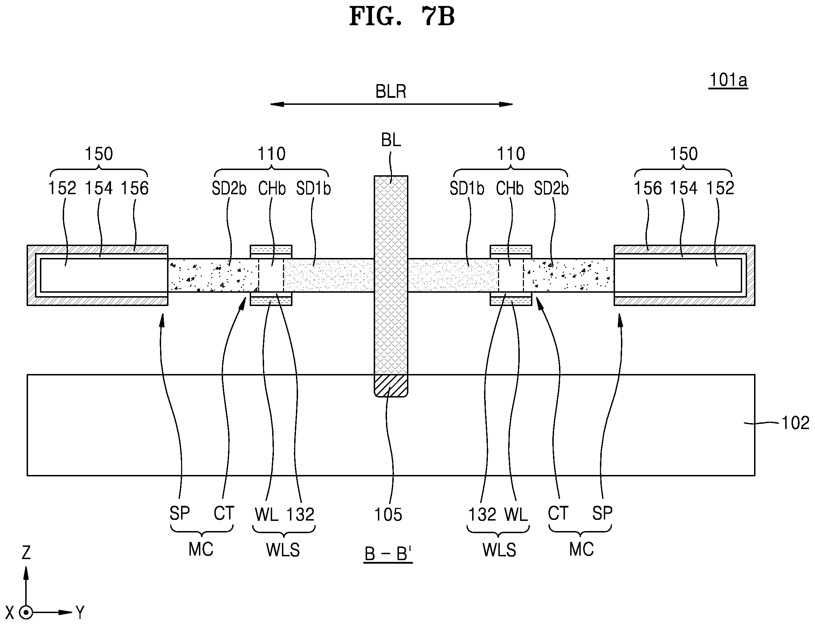

FIGS. 7A and 7B are cross-sectional views illustrating parts of semiconductor memory devices 101 and 101a according to one or more embodiments. For example, FIGS. 7A and 7B are cross-sectional views taken along the line B-B' of FIG. 3A, respectively.

Referring to FIG. 7A, the semiconductor memory device 101 may include the substrate 102, a plurality of word lines WL arranged on the substrate 102 to be apart from a main surface 102M of the substrate 102, a plurality of bit lines BL extending from the main surface 102M of the substrate 102 in the vertical direction (Z direction), a plurality of cell transistors CT arranged between the plurality of word lines WL and the plurality of bit lines BL, and a plurality of information storage elements SP connected to the plurality of cell transistors CT. The plurality of cell transistors CT and the plurality of information storage elements SP may constitute a plurality of memory cells MC.

The word line WL may be adjacent to a semiconductor pattern 110. In some embodiments, the word line WL may surround the semiconductor pattern 110. A gate dielectric layer 132 may be between the word line WL and the semiconductor pattern 110. The word line WL and the gate dielectric layer 132 may constitute a word line structure WLS. The semiconductor pattern 110 and the word line structure WLS may constitute the cell transistor CT.

The semiconductor pattern 110 may include a source region SD1a, a drain region SD2a, and a channel region CHa between the source region SD1a and the drain region SD2a. The source region SD1a may be connected to the bit line BL, and the drain region SD2a may be connected to the information storage element SP. In the process of performing heat treatment to form the source region SD1 described with reference to FIG. 4C, the source region SD1a may be formed by performing heat treatment for a relatively short time.

The channel region CHa may include a portion of the semiconductor pattern 110 overlapping the word line WL in the vertical direction (Z direction) and portions of the semiconductor pattern 110 adjacent to the word line WL. In some embodiments, the channel region CHa may include a portion of the semiconductor pattern 110 passing through the word line WL and portions of the semiconductor pattern 110 adjacent to the word line WL. A length of the channel region CHa in the second horizontal direction (Y direction) may be greater than a length of the word line WL in the second horizontal direction (Y direction). A length of the source region SD1a in the second horizontal direction (Y direction) may be less than a distance between the word line WL and the bit line BL in the second horizontal direction (Y direction).

Referring to FIG. 7B, the semiconductor memory device 101a may include the substrate 102, a plurality of word lines WL arranged on the substrate 102 to be apart from a main surface 102M of the substrate 102, a plurality of bit lines BL extending from the main surface 102M of the substrate 102 in the vertical direction (Z direction), a plurality of cell transistors CT arranged between the plurality of word lines WL and the plurality of bit lines BL, and a plurality of information storage elements SP connected to the plurality of cell transistors CT. The plurality of cell transistors CT and the plurality of information storage elements SP may constitute a plurality of memory cells MC.

The word line WL may be adjacent to a semiconductor pattern 110. In some embodiments, the word line WL may surround the semiconductor pattern 110. A gate dielectric layer 132 may be between the word line WL and the semiconductor pattern 110. The word line WL and the gate dielectric layer 132 may constitute a word line structure WLS. The semiconductor pattern 110 and the word line structure WLS may constitute the cell transistor CT.

The semiconductor pattern 110 may include a source region SD1b, a drain region SD2b, and a channel region CHb between the source region SD1b and the drain region SD2b. The source region SD1b may be connected to the bit line BL, and the drain region SD2b may be connected to the information storage element SP. In the process of performing heat treatment to form the source region SD1 described with reference to FIG. 4C, the source region SD1b may be formed by performing heat treatment for a relatively long time.

The channel region CHb may include part of a portion of the semiconductor pattern 110 overlapping the word line WL in the vertical direction (Z direction). In some embodiments, the channel region CHb may include part of a portion of the semiconductor pattern 110 passing through the word line WL. A length of the channel region CHb in the second horizontal direction (Y direction) may be less than a length of the word line WL in the second horizontal direction (Y direction). A length of the source region SD1b in the second horizontal direction (Y direction) may be greater than a distance between the word line WL and the bit line BL in the second horizontal direction (Y direction).

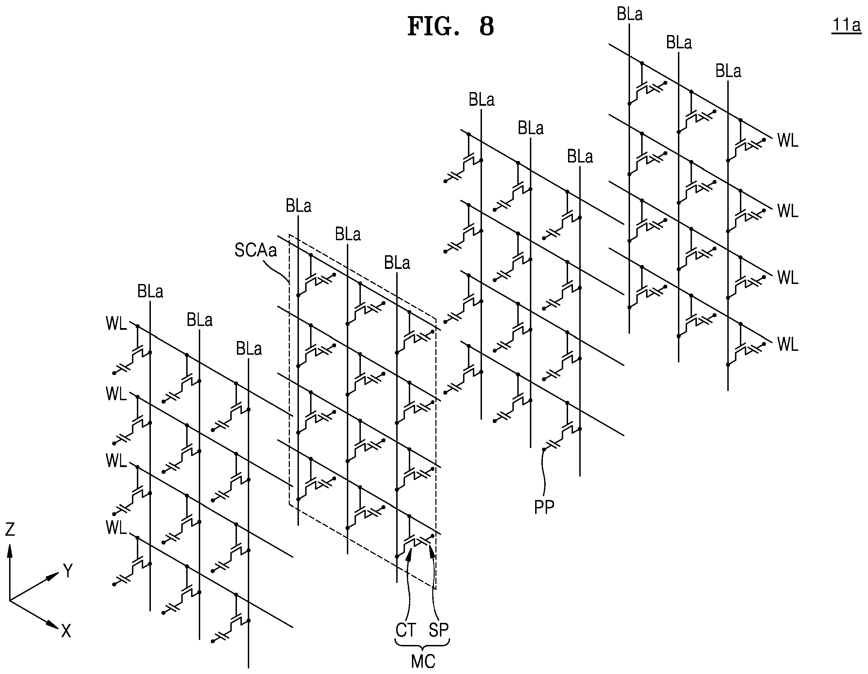

FIG. 8 is an equivalent circuit diagram illustrating a memory cell array 11a of a semiconductor memory device according to one or more embodiments.

Referring to FIG. 8, the memory cell array 11a of the semiconductor memory device according to one or more embodiments may include a plurality of sub-cell arrays SCAa. Each of the plurality of sub-cell arrays SCAa may include a plurality of bit lines BLa, a plurality of word lines WL, and a plurality of memory cells MC. Each of the plurality of memory cells MC includes a cell transistor CT and an information storage element SP. One cell transistor CT may be arranged between one word line WL and one bit line BLa. The plurality of sub-cell arrays SCAa may be arranged in the second horizontal direction (Y direction).

The plurality of word lines WL may extend in a first horizontal direction (X direction). The word lines WL in one sub-cell array SCAa may be apart from one another in a vertical direction (Z direction). The bit line BLa may extend in the vertical direction (Z direction). The bit lines BLa in one sub-cell array SCAa may be apart from one another in the first horizontal direction (X direction).

A gate of the cell transistor CT may be connected to the word line WL, and a source region of the cell transistor CT may be connected to the bit line BLa. The information storage element SP may be connected to a drain region of the cell transistor CT.

In some embodiments, the source region and the drain region of the cell transistor CT and the information storage element SP may be arranged in the second horizontal direction (Y direction) or a direction opposite to the second horizontal direction (Y direction) from the bit line BLa connected to the source region of the cell transistor CT. The source region and the drain region of the cell transistor CT and the information storage element SP connected to two bit lines BLa adjacent to each other in the second horizontal direction (Y direction) may be arranged in opposite directions. For example, the source region and the drain region of the cell transistor CT and the information storage element SP connected to one of the two bit lines BLa adjacent to each other in the second horizontal direction (Y direction) may be sequentially arranged in the second horizontal direction (Y direction), and the source region and the drain region of the cell transistor CT and the information storage element SP connected to the other bit line BLa may be arranged in the direction opposite to the second horizontal direction (Y direction). For example, the plurality of bit lines BLa may include a first bit line, a second bit line, a third bit line, and a fourth bit line sequentially arranged to be adjacent to one another in the second horizontal direction (Y direction), a memory cell MC may not be arranged between the first bit line and the second bit line, two memory cells MC may be arranged between the second bit line and the third bit line at the same vertical level in the second horizontal direction (Y direction), and a memory cell MC may not be arranged between the third bit line and the fourth bit line.

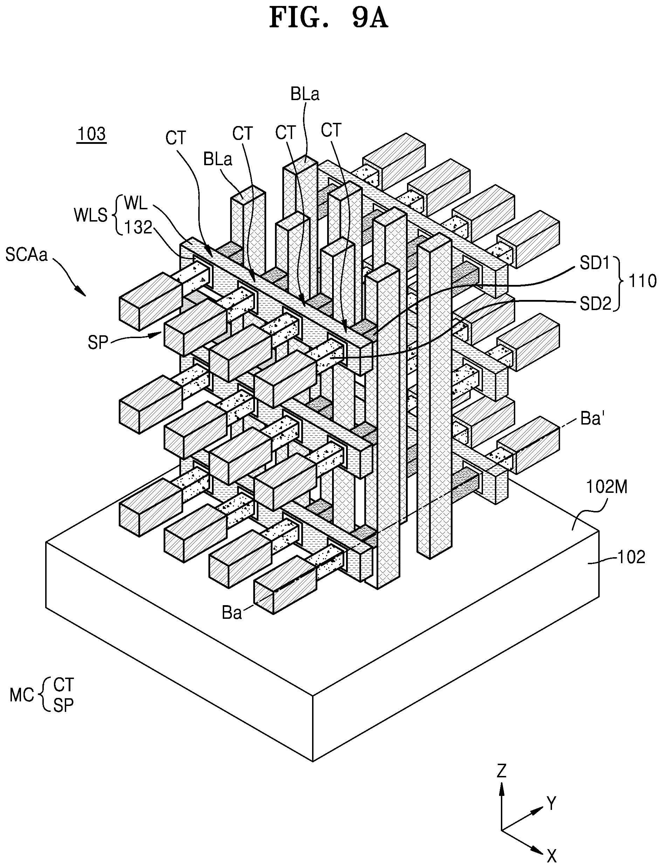

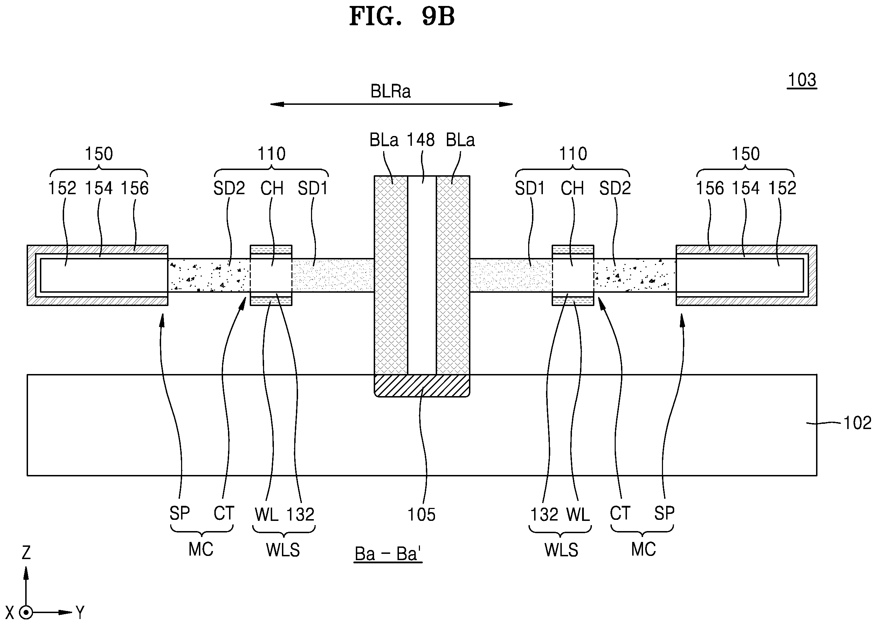

FIG. 9A is a perspective view illustrating part of a semiconductor memory device 103 according to one or more embodiments, and FIG. 9B is a cross-sectional view illustrating part of a semiconductor memory device 103 according to one or more embodiments

Referring to FIGS. 9A and 9B together, the semiconductor memory device 103 includes a substrate 102 and a plurality of sub-cell arrays SCAa. The plurality of sub-cell arrays SCAa may be arranged in the second horizontal direction (Y direction). The sub-cell array SCAa may include the substrate 102, a plurality of word lines WL arranged on the substrate 102 to be apart from a main surface 102M of the substrate 102, a plurality of bit lines BLa extending from the main surface 102M of the substrate 102 in the vertical direction (Z direction), a plurality of cell transistors CT arranged between the plurality of word lines WL and the plurality of bit lines BLa, and a plurality of information storage elements SP connected to the plurality of cell transistors CT. The plurality of cell transistors CT and the plurality of information storage elements SP may constitute a plurality of memory cells MC.

The plurality of word lines WL may extend in the first horizontal direction (X direction) on the substrate 102 and may be apart from one another in the second horizontal direction (Y direction) and the vertical direction (Z direction). The plurality of bit lines BLa may extend in the vertical direction (Z direction) from the substrate 102 and may be apart from one another in the first horizontal direction (X direction) and the second horizontal direction (Y direction).

One cell transistor CT may be arranged between one word line WL and one bit line BLa. The information storage element SP may be connected to the cell transistor CT. The cell transistors CT and the information storage elements SP may be sequentially arranged in the second horizontal direction (Y direction) or the direction opposite to the second horizontal direction (Y direction) from the bit line BLa to which the cell transistors CT are connected.

The source region SD1, a channel region CH, and the drain region SD2 may be sequentially arranged in the second horizontal direction (Y direction) or a direction opposite to the second horizontal direction (Y direction) from the bit line BLa. Two sub-cell arrays SCAa adjacent to each other in the second horizontal direction (Y direction) may not share the bit lines BLa. The source region SD1, the channel region CH, and the drain region SD2 of the cell transistor CT and the information storage element SP connected to two bit lines BLa adjacent to each other in the second horizontal direction (Y direction) may be arranged in opposite directions.

For example, the source region SD1, the channel region CH, and the drain region SD2 of the cell transistor CT and the information storage element SP connected to one of the two bit lines BLa adjacent to each other in the second horizontal direction (Y direction) may be sequentially arranged in the second horizontal direction (Y direction), and the source region SD1, the channel region CH, and the drain region SD2 of the cell transistor CT and the information storage element SP connected to the other bit line BLa may be arranged in the direction opposite to the second horizontal direction (Y direction).

An isolation insulating layer 105 may be between the substrate 102 and the bit line BLa. The bit line BLa may be apart from the substrate 102 with the isolation insulating layer 105 between the bit line BLa and the substrate 102. The isolation insulating layer 105 may electrically insulate the substrate 102 from the bit line BLa. At least part of the isolation insulating layer 105 may be buried in the substrate 102. The isolation insulating layer 105 may be apart from the semiconductor pattern 110. For example, a top surface of the isolation insulating layer 105 may be at a vertical level lower than the bottom surface of the lowermost semiconductor pattern 110. The top surface of the isolation insulating layer 105 may be at a vertical level equal to or higher than the top surface of the substrate 102.

A pair of bit lines BLa adjacent to each other in the second horizontal direction (Y direction) may be arranged on one isolation insulating layer 105. The pair of bit lines BLa arranged on one isolation insulating layer 105 may be apart from each other with the insulating structure 148 between adjacent bit lines BLa. The pair of bit lines BLa adjacent to each other in the second horizontal direction (Y direction) and the insulating structure 148 filling a space between the pair of bit lines BLa may be arranged on one isolation insulating layer 105. The sum of widths of the pair of bit lines BLa adjacent to each other in the second horizontal direction (Y direction) and a width of the insulating structure 148 filling a space between the pair of bit lines BLa in the second horizontal direction (Y direction) may be equal to or substantially equal to a width of the isolation insulating layer 105 in the second horizontal direction (Y direction).

The semiconductor memory device 103 may include the isolation insulating layer 105a illustrated in FIG. 5C, the isolation insulating layer 105b illustrated in FIG. 6A, or the isolation insulating layer 105c illustrated in FIG. 6B instead of the isolation insulating layer 105. Instead of the source region SD1, the channel region CH, and the drain region SD2, the semiconductor memory device 103 may include the source region SD1a, the channel region CHa, and the drain region SD2a illustrated in FIG. 7A or the source region SD1b, the channel region CHb, and the drain region SD2b illustrated in FIG. 7B.

In some embodiments, the information storage element SP may be a capacitor structure 150 including a first electrode 152, a second electrode 156, and a capacitor dielectric layer 154 between the first electrode 152 and the second electrode 156. The capacitor structure 150 may include the first electrode 152 connected to the drain region SD2 of the semiconductor pattern 110 and extending in the second horizontal direction (Y direction). For example, the capacitor dielectric layer 154 may be provided on the first electrode 152, and the second electrode 156 may be provided on the capacitor dielectric layer 154. For example, the capacitor dielectric layer 154 may cover the first electrode 152, and the second electrode 156 may cover the capacitor dielectric layer 154. The second electrode 156 may be connected to the ground wiring PP illustrated in FIG. 8 or may include part of the ground wiring PP.

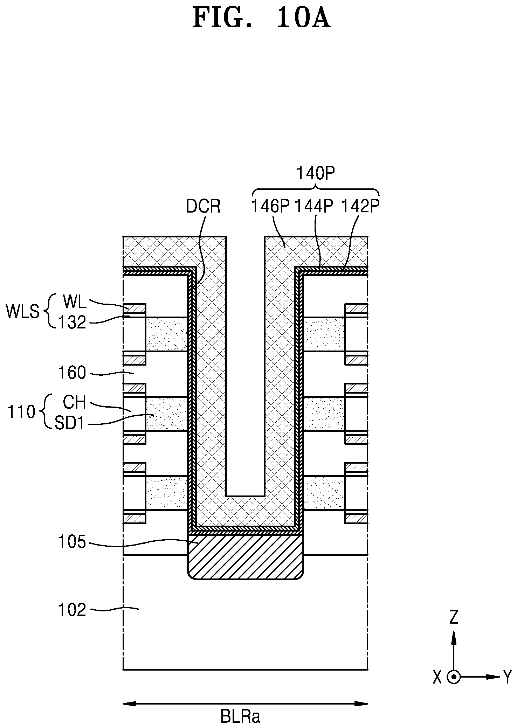

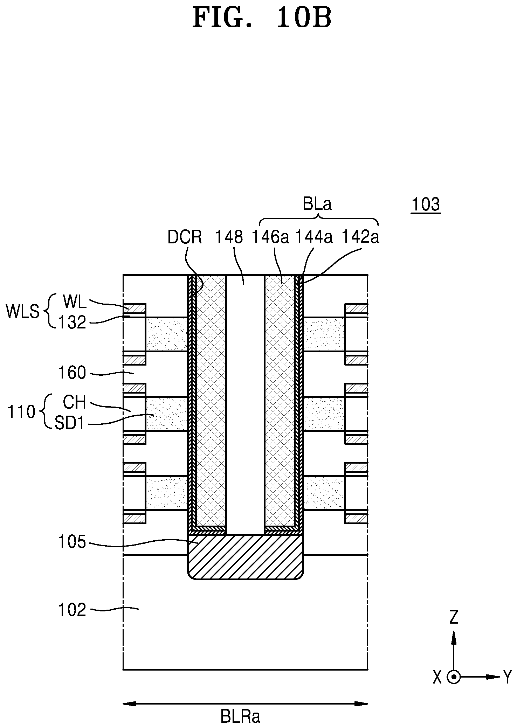

FIGS. 10A and 10B are cross-sectional views illustrating a method of manufacturing a semiconductor memory device according to one or more embodiments. For example, FIGS. 10A and 10B are cross-sectional views illustrating a portion corresponding to a region BLRa of FIG. 9B.

Referring to FIG. 10A, after forming the isolation insulating layer 105 illustrated in FIG. 4D, a bit line material layer 140P is formed to fill part of the isolation recess DCR. The bit line material layer 140P may be formed on the internal and bottom surfaces of the isolation recess DCR. For example, the bit line material layer 140P may be formed to cover the internal and bottom surfaces of the isolation recess DCR. However, in some embodiments, the bit line material layer 140P may not to completely fill the isolation recess DCR. According to an embodiment, the bit line material layer 140P may be formed on the surfaces of the plurality of interlayer insulating layers 160 and the plurality of semiconductor patterns 110 exposed to the internal surface of the isolation recess DCR on the isolation insulating layer 105, the top surface of the isolation insulating layer 105, and a top surface of the stacked structure of the plurality of interlayer insulating layers 160 and the plurality of semiconductor patterns 110. For example, the bit line material layer 140P may be formed to cover the surfaces of the plurality of interlayer insulating layers 160 and the plurality of semiconductor patterns 110 exposed to the internal surface of the isolation recess DCR on the isolation insulating layer 105, the top surface of the isolation insulating layer 105, and a top surface of the stacked structure of the plurality of interlayer insulating layers 160 and the plurality of semiconductor patterns 110. In some embodiments, the bit line material layer 140P may include a metal silicide material layer 142P, a conductive barrier material layer 144P, and a conductive filling material layer 146P. The metal silicide material layer 142P, the conductive barrier material layer 144P, and the conductive filling material layer 146P may be formed of same or substantially same material as the metal silicide layer 142, the conductive barrier layer 144, and the conductive filling layer 146 illustrated in FIG. 4E.

Referring to FIGS. 10A and 10B together, part of the bit line material layer 140P is removed so that part of the top surface of the isolation insulating layer 105 and the top surface of the stacked structure of the plurality of interlayer insulating layers 160 and the plurality of semiconductor patterns 110 are exposed to form a pair of bit lines BLa arranged in one isolation recess DCR. The pair of bit lines BLa may be formed by removing part of the bit line material layer 140P provided on the top surface of the isolation insulating layer 105 and a portion of the bit line material layer 140P provided on the top surface of the stacked structure of the plurality of interlayer insulating layers 160 and the plurality of semiconductor patterns 110. For example, the pair of bit lines BLa may be formed by removing part of the bit line material layer 140P covering the top surface of the isolation insulating layer 105 and a portion of the bit line material layer 140P covering the top surface of the stacked structure of the plurality of interlayer insulating layers 160 and the plurality of semiconductor patterns 110. Residual portions of the metal silicide material layer 142P, the conductive barrier material layer 144P, and the conductive filling material layer 146P included in the bit line material layer 140P may be the metal silicide layer 142a, the conductive barrier layer 144a, and the conductive filling layer 146a included in the bit line BLa. Thereafter, an insulating structure 148 filling the isolation recess DCR may be formed to form the semiconductor memory device 103. The insulating structure 148 may include silicon oxide, silicon nitride, silicon oxynitride, or a combination thereof. However, the disclosure is not limited thereto.
While the disclosure has been particularly shown and described with reference to embodiments thereof, it will be understood that various changes in form and details may be made therein without departing from the scope of the following claims.

## Claims

1. A semiconductor memory device comprising:
a substrate (102);
an isolation insulating layer (105; 105a; 105b; 105c) on and/or in the substrate (102);
a plurality of word lines (WL) on the substrate (102), the plurality of word lines (WL) extending in a first horizontal direction (X) and being apart from each other in a vertical direction (Z);
a bit line (BL, BLa) extending in the vertical direction (Z) on the isolation insulating layer (105; 105a; 105b; 105c);
a plurality of semiconductor patterns (110) extending from the bit line (BL, BLa) in a second horizontal direction (Y) orthogonal to the first horizontal direction (X) and apart from each other in the vertical direction (Z); and
a plurality of information storage elements (SP) connected to the plurality of semiconductor patterns (110),
wherein each of the plurality of semiconductor patterns (110) comprises:
a source region (SD1; SD1a; SD1b) connected to the bit line (BL, BLa), the source region (SD1; SD1a; SD1b) comprising a same impurity as the isolation insulating layer (105; 105a; 105b; 105c),
a drain region (SD2; SD2a; SD2b) connected to one of the plurality of information storage elements (SP), and
a channel region (CH; CHa; CHb) between the source region (SD1; SD1a; SD1b) and the drain region (SD2; SD2a; SD2b) and at least partially overlapping one of the plurality of word lines (WL), in the vertical direction (Z).

2. The semiconductor memory device of claim 1, wherein a width of the bit line (BL, BLa) is equal to a width of the isolation insulating layer (105; 105a; 105b; 105c) in the second horizontal direction (Y).

3. The semiconductor memory device of claim 1 or 2, wherein the isolation insulating layer (105; 105a; 105b; 105c) is provided between the bit line (BL, BLa) and the substrate (102).

4. The semiconductor memory device of any one of claims 1 to 3, wherein each of the source region (SD1; SD1a; SD1b) and the isolation insulating layer (105; 105a; 105b; 105c) comprises phosphorus as an impurity.

5. The semiconductor memory device of any one of claims 1 to 4, wherein, in the vertical direction (Z), a top surface of the isolation insulating layer (105; 105a; 105b; 105c) is at a level lower than a bottom surface of a lowermost semiconductor pattern (110) among the plurality of semiconductor patterns (110) and higher than a top surface of the substrate (102).

6. The semiconductor memory device of any one of claims 1 to 4, wherein the isolation insulating layer(105; 105a; 105b; 105c) is buried in the substrate (102), and
wherein a top surface of the isolation insulating layer (105; 105a; 105b; 105c) is at a same vertical level as a top surface of the substrate (102).

7. The semiconductor memory device of any one of claims 1 to 6, wherein a length of the channel region (CH) in the second horizontal direction (Y) is equal to a length of the one of the plurality of word lines (WL) in the second horizontal direction (Y).

8. The semiconductor memory device of any one of claims 1 to 6, wherein a length of the channel region (CHa) in the second horizontal direction (Y) is greater than a length of the one of the plurality of word lines (WL) in the second horizontal direction (Y).

9. The semiconductor memory device of any one of claims 1 to 6, wherein a length of the channel region (CHb) in the second horizontal direction (Y) is less than a length of the one of the plurality of word lines (WL) in the second horizontal direction (Y).

10. The semiconductor memory device of any one of claims 1 to 9, wherein the bit line (BL, BLa) comprises a metal.

11. The semiconductor memory device of any one of claims 1 to 10, wherein:
the bit line (BL, BLa) comprises a metal;
the plurality of word lines (WL) comprise a first word line provided on a first side of the bit line (BL, BLa) and a second word line provided on a second side of the bit line (BL, BLa), the first word line and the second word line bering apart from each other in a second horizontal direction (Y) orthogonal to the first horizontal direction (X);
the plurality of semiconductor patterns (110) comprise a first semiconductor pattern provided on the first side of the bit line (BL, BLa) and a second semiconductor pattern provided on the second side of the bit line (BL, BLa), the first semiconductor pattern partially overlapping the first word line in the vertical direction (Z).

12. The semiconductor memory device of any one of claims 1 to 11, wherein the isolation insulating layer (105; 105a; 105b; 105c) is provided on an entire bottom surface of the bit line (BL, BLa).

13. The semiconductor memory device of any one of claims 1 to 12, wherein the source region (SD1; SD1a; SD1b) has an n-type conductivity, and
wherein the impurity in the isolation insulating layer (105; 105a; 105b; 105c) is phosphorus.

14. The semiconductor memory device of any one of claims 1 to 13, wherein each of the plurality of semiconductor patterns (110) extends through one of the plurality of word lines (WL).

15. The semiconductor memory device of any one of claims 1 to 14, wherein:
the isolation insulating layer (105; 105a; 105b; 105c) is buried in the substrate (102) and protrudes from a top surface of the substrate (102);
the bit line (BL, BLa) is apart from the substrate (102) and comprises a metal;
the plurality of word lines (WL) comprise a first word line provided on a first side of the bit line (BL, BLa) and a second word line provided on a second side of the bit line (BL, BLa), the first word line and the second word line being apart from each other in a second horizontal direction (Y) orthogonal to the first horizontal direction (X);
the plurality of semiconductor patterns (110) comprises a first semiconductor pattern provided on the first side of the bit line (BL, BLa) and a second semiconductor pattern provided on the second side of the bit line (BL, BLa), the first semiconductor pattern passing through the first word line; and
the plurality of storage elements comprises a plurality of capacitor structures connected to the plurality of semiconductor patterns (110) and each of the plurality of capacitor structures comprising:
a first electrode,
a second electrode, and
a capacitor dielectric layer between the first electrode and the second electrode,
wherein the drain region (SD2; SD2a; SD2b) is connected to the first electrode of one of the plurality of capacitor structures.
